Europäisches Patentamt

European Patent Office

Office européen des brevets

(11) Publication number: **0 374 378 B1**

# EUROPEAN PATENT SPECIFICATION

(45) Date of publication of patent specification: **07.04.93**

(51) Int. Cl.⁵: **C04B 35/00**, H01L 41/187, C04B 35/49

(21) Application number: **89117108.4**

(22) Date of filing: **15.09.89**

(54) Piezoelectric ceramic and manufacturing method thereof.

(30) Priority: **23.12.88 JP 325290/88**

(43) Date of publication of application:
**27.06.90 Bulletin 90/26**

(45) Publication of the grant of the patent:
**07.04.93 Bulletin 93/14**

(84) Designated Contracting States:
**DE FR GB IT**

(56) References cited:
**EP-A- 0 356 839**
**EP-A- 0 364 639**
**EP-A- 0 368 619**
**AT-B- 254 026**
**US-A- 4 236 928**

(73) Proprietor: **TAIYO YUDEN KABUSHIKI KAISHA No. 16-20, Ueno 6-chome Taito-ku Tokyo(JP)**

(72) Inventor: **Nagasawa, Seizi c/o Taiyo Yuden K.K. No. 16-20, Ueno 6-chome Taito-ku Tokyo(JP)**
Inventor: **Narita, Naoto c/o Taiyo Yuden K.K. No. 16-20, Ueno 6-chome Taito-ku Tokyo(JP)**
Inventor: **Mizuno, Yoichi c/o Taiyo Yuden K.K. No. 16-20, Ueno 6-chome Taito-ku Tokyo(JP)**

(74) Representative: **Schmidt-Evers, Jürgen, Dipl.-Ing. et al Patentanwälte Dipl.-Ing. H. Mitscherlich Dipl.-Ing. K. Gunschmann Dipl.-Ing. Dr.rer.nat. W. Körber Dipl.-Ing. J. Schmidt-Evers Dipl.-Ing. W. Melzer Steinsdorfstrasse 10 W-8000 München 22 (DE)**

## Description

(Industrial Field of Application)

This invention relates to a piezoelectric ceramic that can be used as various types of electromechanical transducer elements for a buzzer, an actuator, a pressure sensor or the like and to a manufacturing method thereof. More specifically, it relates to a piezoelectric ceramic that can be produced by sintering at a temperature of 850ºC or even lower and to a manufacturing method thereof.

(Prior Art)

Piezoelectric ceramics of this kind known heretofore include a two-component system solid solution comprising, for example, lead titanate $[PbTiO_3]$ and lead zirconium $[PbZrO_3]$; a three-component system solid solution such as $[Pb(Mg_{1/3}Nb_{2/3})O_3-PbTiO_3-PbZrO_3]$ which comprises the foregoing two-component system solid solution and one kind of composite perovskite oxide added thereto; another three-component system solid solution comprising in place of the $[Pb(Mg_{1/3}Nb_{2/3})O_3]$ component of the foregoing three-component system solid solution one of $[Pb(Ni_{1/3}Nb_{2/3})O_3]$, $[Pb(Y_{1/3}Nb_{2/3})O_3]$ and $[Pb(Co_{1/3}Nb_{2/3})O_3]$; and a four-component system solid solution comprising said two-component system solid solution and two kinds of composite perovskite oxides added thereto.

While temperatures at which these known piezoelectric ceramics are sintered range generally between 1100ºC and 1300ºC, the melting point of PbO contained in such a piezoelectric ceramic is 1000ºC or lower and said PbO thus has a vapor pressure of several thousands of Pascal (tens of torr) at said sintering temperature, so that it is extremely difficult to prevent PbO from evaporating under this condition. Since PbO vapors are highly harmful to humans, it is by all means necessary to provide a preventative measure to avoid diffusion into the atmosphere of the vapors. In addition, when PbO is evaporated, the PbO component contained in a piezoelectric ceramic obtained by sintering is quantitatively uneven in a sinter and between sinters. This causes such problems as partially uneven baking in the sinter and/or disparity in performance characteristics between the sinters of different lots due to an A-site defect of the ceramic.

To solve the foregoing problems, there has been proposed, as disclosed in the Japanese Examined Patent Application Publication Tokkosho 62-57594, a manufacturing method of a piezoelectric ceramic in which calcined powder consisting of an alkaline metallic salt and $PbF_2$ is added to calcined powder of lead titanate.zirconate as a sintering temperature depressant to carryout sintering at a temperature lower than the melting point of PbO, thereby preventing PbO from evaporating during sintering.

(Problems to be Solved by the Invention)

However, since an alkaline metallic salt is contained in the sintering temperature depressant as one component thereof in the foregoing manufacturing method, the alkaline metallic salt which is water-soluble is partially eluted into an aqueous solvent used during the manufacturing process of the material powder, thus causing the quantity of the alkaline metallic salt contained in the material powder to be inconsistent from lot to lot. Consequently, there arises a problem of component ratio disparity among the piezoelectric ceramics obtained by such method. Furthermore, since the piezoelectric ceramic obtained by said method contains an alkaline salt, there is in general a danger that the alkaline metallic salt may be gradually eluted out of the ceramic when placed in water or in a high-humidity environment. This gives rise to a reliability problem, especially in view of the existing industrial standard on electronic parts that electrical characteristics of an electronic part should remain undeteriorated even when left under humidity of 90% RH or higher for 1000 hours.

It is, therefore, the object of the present invention to provide a piezoelectric ceramic and manufacturing method thereof that are free from the foregoing problems.

(Means for Solving the Problems)

To attain the above object, the present invention provides a piezoelectric ceramic mainly composed of a lead system oxide, said ceramic being characterized in that it contains at least one of lead iron tungstate $[Pb(Fe_{2/3}W_{1/3})O_3]$, lead copper tungstate $[Pb(Cu_{1/2}W_{1/2})O_3]$, lead cobalt tungstate $[Pb(Co_{1/2}W_{1/2})O_3)$, lead nickel tungstate $[Pb(Ni_{1/2}W_{1/2})O_3]$, and lead zinc tungstate $[Pb(Zn_{1/2}W_{1/2})O_3]$, and an A-site/B-site molar ratio thereof is 1.01 or higher, except for the lead oxide tungstate-containing ceramics of the general formula $Pb[(Ni_{1/3}Nb_{2/3})_a (Zn_{1/3}Nb_{2/3})_b (Fe_{2/3}W_{1/3})_c (Ti_xZr_y)d]O_3$, wherein $a+b+c+d=1$, $0.20<a+b<0.50$,

$0.02 < c < 0.15$, and $x + y = 1$, the materials of the formulae $Pb_{1.02}(Mg_{1/3}Nb_{2/3})_{0.70}$ $Ti_{0.18}(Ni_{1/2}W_{1/2})_{0.12}O_{3.02}$ + optionally certain amounts of $Cu_2O$, and the ceramic compositions comprising the ceramic components expressed as $PbTi_x(Mg_{1/3}Nb_{2/3})_y$ $(Ni_{1/2}W_{1/2})_zO_3$, wherein $x + y + z = 1$ and, in the system of trigonometric coordinates having the vertices at $PbTiO_3$, $Pb(Mg_{1/3}Nb_{2/3})O_3$ and $Pb(Ni_{1/2}W_{1/2})O_3$, PbO by 1.0 to 25.0 mol% and NiO or $WO_3$ by 1.0 to 15.0 mol% are added as subsidiary components to the temporarily baked powder of the main component dielectric composition formed in the pentagonal region having vertices at components A.B.C.D.E expressed by the numerical values in the following square bracket, [A is $x = 2.5$, $y = 95.0$, $z = 2.5$; B is $x = 12.5$, $y = 85.0$, $z = 2.5$; C is $x = 60.0$, $y = 10.0$, $z = 30.0$; D is $x = 40.0$, $y = 10.0$, $z = 50.0$; E is $x = 2.5$, $y = 90.0$, $z = 7.5$ (where all units are mol%)].

Further, it is preferable that the A-site/B-site molar ratio of the solid-solution ceramic is in the range of 1.01 to 1.03 for the purpose of preventing the dielectric strength of the piezoelectric ceramic from becoming low.

The present invention also provides a manufacturing method of the above piezoelectric ceramic in which material powders for the piezoelectric ceramic mainly composed of a lead system oxide are mixed and sintered to manufacture a piezoelectric ceramic, said method being characterized in that a mixture of the material powders arranged to comprise tungsten oxide and in addition thereto at least one of iron oxide, copper oxide, cobalt oxide, nickel oxide and zinc oxide and adjusted to have the A-site/B-site molar ratio of 1.01 or higher is sintered so that the piezoelectric ceramic mainly composed of a lead system oxide has in solid solution at least one of lead iron tungstate $[Pb(Fe_{2/3} W_{1/3}) O_3]$, lead copper tungstate $[Pb(Cu_{1/2} W_{1/2}) O_3]$, lead cobalt tungstate $[Pb(Co_{1/2} W_{1/2} O_3]$, lead nickel tungstate $[Pb(Ni_{1/2} W_{1/2}) O_3]$ and lead zinc tungstate $[Pb(Zn_{1/2} W_{1/2}) O_3]$.

(Operation)

The material used to manufacture a piezoelectric ceramic according to the present invention contains a lead system oxide as its main component and in addition thereto tungsten oxide plus at least one of iron oxide, copper oxide, cobalt oxide, nickel oxide and zinc oxide, all of them being an oxide and thus not eluted in an aqueous solvent. Such a solid solution as lead iron tungstate $[Pb(Fe_{2/3} W_{1/2}) O_3]$, lead copper tungstate $[Pb(Cu_{1/2} W_{1/2}) O_3]$, lead cobalt tungstate $[Pb(Co_{1/2}W_{1/2}) O_3]$, lead nickel tungstate $[Pb(Ni_{1/2} W_{1/2})$ $O_3]$, or lead zinc tungstate $[Pb(Zn_{1/2} W_{1/2}) O_3]$ formed when the foregoing material substances are mixed and sintered acts as a sintering temperature depressant.

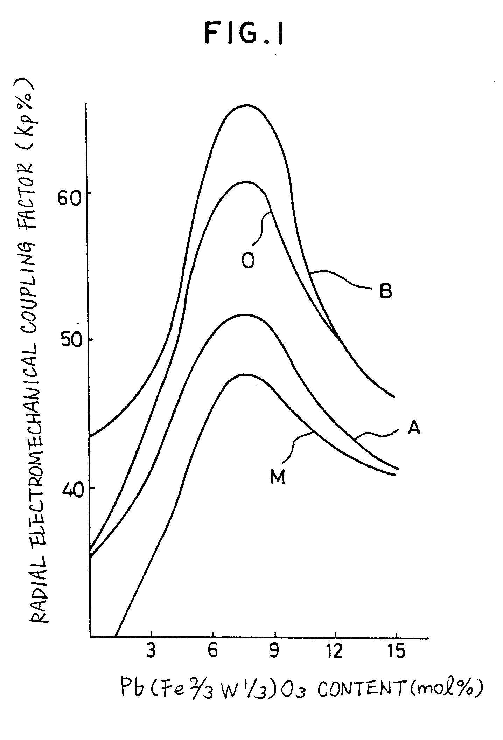

Figures 1 and 3 through 7 are each a characteristic diagram showing relationship between radial electromechanical coupling factors of piezoelectric ceramics manufactured according to the embodiment examples of the present invention and varied quantities of each metallic lead tungstate contained in said piezoelectric ceramics; and

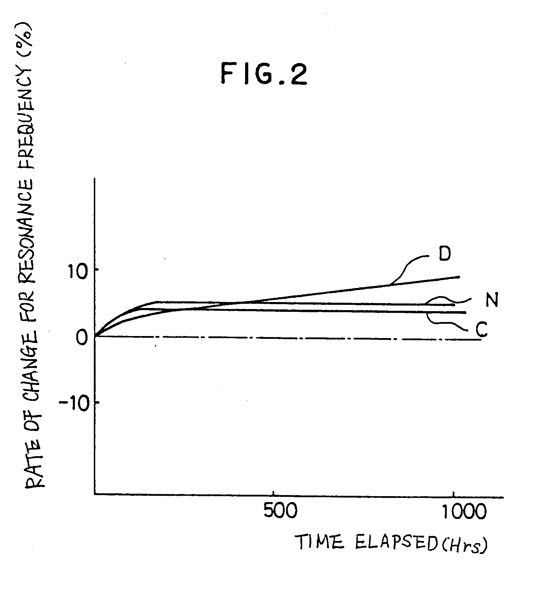

Figure 2 is a characteristic diagram showing relationship between the rate of change for resonance frequency before and after the piezoelectric ceramics made according to the embodiment examples of the present invention and the comparison example were left under the condtion of 85°C in temperature and 90% RH in relative humidity for a predetermined period of time and progress of time within said predetermined period of time.

Now, embodiment examples of the present invention together with a comparison example will be explained for one to understand the present invention better.

Embodiment Example 1:

To begin with, each of the industrial-use metal oxide powders, lead oxide (PbO), titanium oxide ($TiO_2$), zirconium oxide ($ZrO_2$), iron oxide ($Fe_3O_2$) and tungsten oxide ($WO_3$) was accurately weighed so as to be able to obtain a below-indicated composition, that is,

$(1-X)Pb_{1.02}(Ti_{0.52}Zr_{0.48})O_3$ + $X.Pb_{1.02}(Fe_{2/3}W_{1/3})O_3$,

where $O < X \leq 0.15$.

Of these powders, the zirconium oxide, iron oxide and titanium oxide powders were mixed together with water by a wet ball mill for 10 hours and then dehydrated. The mixture so obtained was calcined at 1000°C in the atmosphere for two hours and then pulverized to obtain calcined powder thereof. Next, the remaining lead oxide and titanium oxide powders were added to the calcined powder. They were then mixed together with water by a wet ball mill again for 10 hours, ground into powder, dehydrated and dried thereafter, and further calcined at 750°C for two hours, and finally pulverized to obtain a powdered ceramic material. After adding to the powdered ceramic material an appropriate quantity of polyvinyl alcohol as a binder and kneading them together, the mixture was granulated. Grains obtained by this granulation process were put in a disk-shaped mold and then formed under pressure of 49 MPa (500 kg/cm$^2$) into a small disk measuring 10 mm in diameter and 0.35 mm in thickness. Each small disk-shaped material so obtained was then sintered at 850°C in the atmosphere for two hours to obtain a sintered product. An Ag electrode was then baked onto each of both surfaces of each such sintered product at the temperature of 800°C and thereafter applied with electric power voltage of 3.0 KV/mm in silicon oil having a temperature of 60°C for 30 minutes for a polarization treatment to obtain test samples.

Each of these piezoelectric ceramic test samples so obtained was measured to obtain radial electro-mechanical coupling factor (Kp%) thereof. The curve A shown in Fig. 1 represents the results of said measurement.

In addition, the test sample having the component ratio of 0.1 for X was measured to obtain resonance frequency (fa$_o$) thereof, then left in a thermostatic oven having the temperature of 85°C and relative humidity of 90%RH for a predetermined period of time, and thereafter measured again to obtain resonance frequency (fa$_1$) thereof. The rate of change for resonance frequency between before and after the predetermined period of time was calculated according to the below-indicated formula:

$$\text{Rate of change} = \frac{fa_o - fa_1}{fa_o} \times 100 \ (\%)$$

The curve C in Fig. 2 represents the rate of change so calculated and plotted with time progress for the predetermined period of time.

Example 2 (Comparative):

The industrial-use metal oxide powders used in this embodiment example were lead oxide (PbO), titanium oxide (TiO$_2$), zirconium oxide (ZrO$_2$), iron oxide (Fe$_3$O$_2$), tungsten oxide (WO$_3$), niobium oxide (Nb$_2$O$_5$), nickel oxide (NiO), and zinc oxide (ZnO) powders. Each of them was accurately weighed so as to be able to obtain a composition expressed by the chemical formula below.

$(1-X)Pb_{1.02} [(Ni_{1/3}Nb_{2/3})_{0.28} (Zn_{1/3}Nb_{2/3})_{0.12}.Ti_{0.36}Zr_{0.24}] O_3 + X.Pb_{1.02}(Fe_{2/3}W_{1/3}) O_3,$

where $O < X \leq 0.15$.

Test samples here were prepared in the same manner as in the Embodiment Example 1 except that the first mixture of the industrial-use metal oxide powders comprised the zirconium oxide, iron oxide, tungsten oxide, nickel oxide, niobium oxide and nickel oxide powders. Also in the same manner as in the Embodiment Example 1, the radial electro-mechanical coupling factor was measured and the results obtained are given as the curve B in Fig. 1.

Further, the test sample having the component ratio of 0.1 for X was measured of resonance frequency before and after left in the thermostatic oven for the predetermined period of time and the rate of change for resonance frequency between before and after left in the oven was calculated as in the Embodiment Example 1. The results were found to be equivalent to those in the Embodiment Example 1.

Embodiment Example 3:

The industrial-use metal oxide powders used here were the lead oxide (PbO), titanium oxide (TiO$_2$), zirconium oxide (ZrO$_2$), copper oxide (CuO), and tungsten oxide (WO$_3$) powders. They were accurately weighed so as to be able to obtain a composition expressed by the chemical formula below.

$(1-X)Pb_{1.02}(Ti_{0.48}Zr_{0.52})O_3 + X.Pb_{1.02}(Cu_{1/2}W_{1/3})O_3,$

where $O < X \leq 0.15$.

Test samples here were prepared in the same manner as in the Embodiment Example 1 except that the first mixture of the industrial-use metal oxide powders comprised the zirconium oxide, copper oxide and tungsten oxide powders.

4

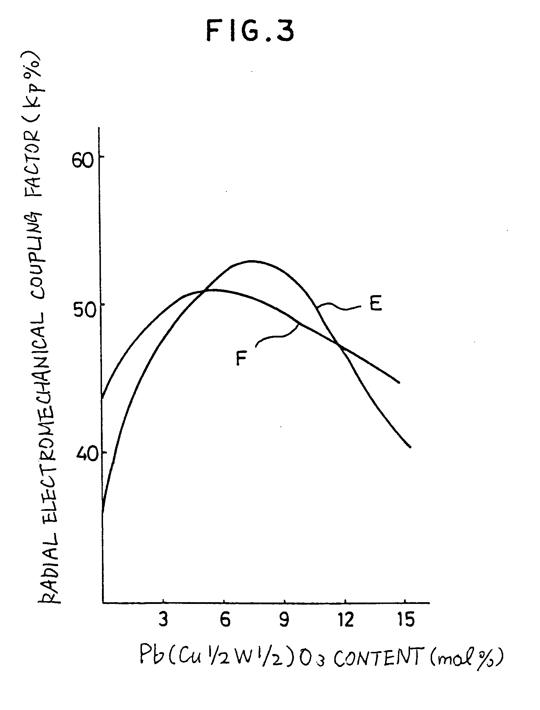

The radial electromechanical coupling factor of each test sample was measured in the same manner as in the Embodiment Example 1. The curve E in Fig. 3 shows the results obtained.

Further, the test sample having the component ratio of 0.1 for X was measured of resonance frequency before and after left in the thermostatic oven as in the Embodiment Example 1 and the rate of change for resonance frequency between before and after left in the oven was also calculated as in the Embodiment Example 1. The results obtained were found to be equivalent to those in the Embodiment Example 1.

Embodiment Example 4:

The industrial-use metal oxide powders used here were the lead oxide (PbO), titanium oxide ($TiO_2$), zirconium oxide ($ZrO_2$), copper oxide (CuO), tungsten oxide ($WO_3$), niobium oxide ($Nb_2O_5$), nickel oxide (NiO), and zinc oxide (ZnO) powders. They were accurately weighed so as to be able to obtain a composition expressed by the chemical formula below.

$$(1-X)Pb_{1.02}[(Ni_{1/3}Nb_{2/3})_{0.28}(Zn_{1/3}Nb_{2/3})_{0.12}.Ti_{0.29}Zr_{0.31}]O_3, + X \cdot Pb_{1.02}(Cu_{1/2}W_{1/2})O_3,$$

where $O<X \leq 0.15$.

Test samples were prepared in the same manner as in the Embodiment Example 1 except that the first mixture of the industrial-use metal oxide powders comprised the circonium oxide, copper oxide, tungsten oxide, nickel oxide, niobium oxide, and zinc oxide powders.

Also in the same manner as in the Embodiment Example 1, the radial electromechanical coupling factor of each sample was measured. The curve F in Fig. 3 represents the result so obtained.

Further, the test sample having the component ratio of 0.1 for X was measured of resonance frequency before and after left in the thermostatic oven as in the Embodiment Example 1 and the rate of change for resonance frquency between before and after left in the oven was calculated also as in the Embodiment Example 1. The results so obtained were found to be equivalent to those in the Embodiment Example 1.

Embodiment Example 5:

The industrial-use metal oxide powders used here were the lead oxide (PbO), titanium oxide ($TiO_2$), zirconium oxide ($ZrO_2$), cobalt oxide (CoO), and tungsten oxide ($WO_3$) powders. They were accurately weighed so as to be able to obtain a composition expressed by the chemical formula below.

$$(1-X)Pb_{1.02}(Ti_{0.48}Zr_{0.52})O_3 + X . Pb_{1.02}(Co_{1/2}W_{1/2})O_3,$$

where $O<X \leq 0.15$.

Test samples were prepared in the same manner as in the Embodiment Example 1 except that the first mixture of the industrial-use metal oxide powders comprised the zirconium oxide, cobalt oxide and tungsten oxide powders.

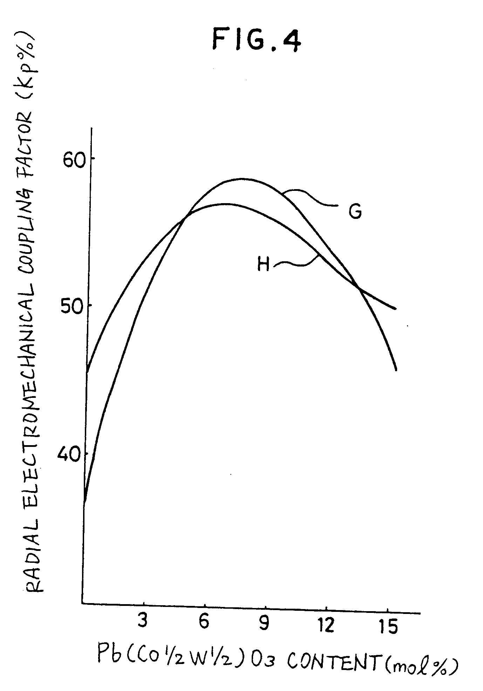

Also in the same manner as in the Embodiment Example 1, the radial electromechanical coupling factor of each test sample was measured. The results obtained were indicated by the curve G in Fig. 4.

Further, the test sample having the component ratio of 0.1 for X was measured of resonance frequency before and after left in the thermostatic oven as in the Embodiment Example 1 and the rate of change for resonance frequency between before and after left in the oven was calculated also as in the Embodiment Example 1. The results so obtained were found to be equivalent to those in the Embodiment Example 1.

Embodiment Example 6:

The industrial-use metal oxide powders used were the lead oxide (PbO), titanium oxide ($TiO_2$), zirconium oxide ($ZrO_2$), cobalt oxide (CoO), tungsten oxide ($WO_3$), niobium oxide ($Nb_2O_5$), nickel oxide (NiO), and zinc oxide (ZnO) powders. They were accurately weighed so as to be able to obtain a composition expressed by the chemical formula below.

$$(1-X)Pb_{1.02}[(Ni_{1/3}Nb_{2/3})_{0.28}(Zn_{1/3}Nb_{2/3})_{0.12}.Ti_{0.29}Zr_{0.31}]O_3 + X.Pb_{1.02}(Co_{1/2}W_{1/2})O_3,$$

where $O<X \leq 0.15$.

Test samples were prepared in the same manner as in the Embodiment Example 1 except that the first mixture of the industrial-use metal oxide powders comprised the zirconium oxide, cobalt oxide, tungsten

5

oxide, nickel oxide, niobium oxide, and zinc oxide powders.

Also in the same manner as in the Embodiment Example 1, the radial electromechanical coupling factor of each test sample was measured. The curve H in Fig. 4 represents the results so obtained.

Further, the test sample having the component ratio of 0.1 for X was measured of resonance frequency before and after left in the thermostatic oven as in the Embodiment Example 1 and the rate of change for resonance frequency between before and after left in the oven was calculated also as in the Embodiment Example 1. The results so obtained were found to be equivalent to those in the Embodiment Example 1.

Embodiment Example 7:

The industrial-use metal oxide powders used were the lead oxide (PbO), titanium oxide ($TiO_2$), zirconium oxide ($ZrO_2$), nickel oxide (NiO), and tungsten oxide ($WO_3$) powders. They are accurately weighed to as to be able to obtain a composition expressed by the chemical formula below.

$$(1-X)Pb_{1.02}(Ti_{0.48}Zr_{0.52})\,O_3 \; + \; X \cdot Pb_{1.02}(Ni_{1/2}W_{1/2})\,O_3,$$

where $O<X \leq 0.15$.

Test samples were prepared in the same manner as in the Embodiment Example 1 except that the first mixture of the industrial-use metal oxide powders comprised the zirconium oxide, nickel oxide, and tungsten oxide powders.

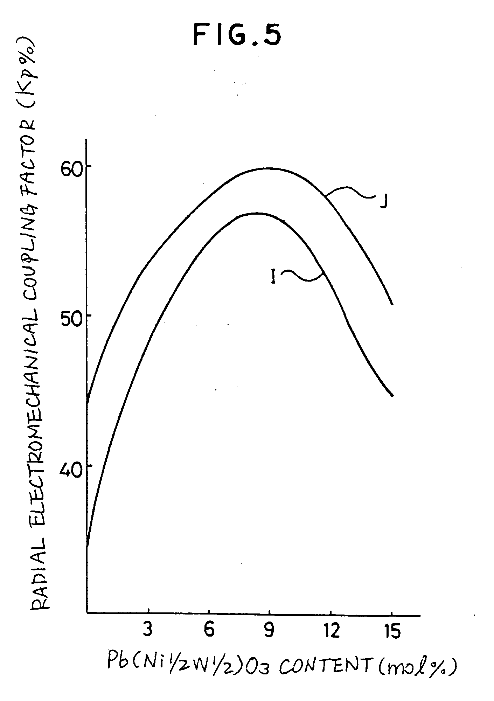

Also in the same manner as in the Embodiment Example 1, the radial electromechanical coupling factor of each test sample was measured. The curve I in Fig. 5 represents the results so obtained.

Further, the test sample having the component ratio of 0.1 for X was measured of resonance frequency before and after left in the thermostatic oven as in the Embodiment Example 1 and the rate of change for resonance frequency between before and after left in the oven was calcualted also as in the Embodiment Example 1. The results so obtained were found to be equivalent to those in the Embodiment Example 1.

Embodiment Example 8:

The industrial-use metal oxide powders used were the lead oxide (PbO), titanium oxide ($TiO_2$), zirconium oxide ($ZrO_2$), nickel oxide (NiO), tungsten oxide ($WO_3$), niobium oxide ($Nb_2O_5$), and zinc oxide (ZnO) powders. They were accurately weighed so as to be able to obtain a composition expressed by the chemical formula below.

$$(1-X)Pb_{1.02}[(\,Ni_{1/3}Nb_{2/3})_{0.28}(Zn_{1/3}Nb_{2/3})_{0.12} \cdot Ti_{0.29}Zr\,0.31]O_3 \; + \; X \cdot Pb_{1.02}(Ni_{1/2}W_{1/2})O_3,$$

where $O<X \leq 0.15$.

Test samples were prepared in the same manner as in the Embodiment Example 1 except that the first mixture of the industrial-use metal oxide powders comprised the zirconium oxide, nickel oxide, tungsten oxide, niobium oxide and zinc oxide powders.

Also in the same manner as in the Embodiment Example 1, the radial electromechanical coupling factor of each test sample was measured. The curve J in Fig. 5 represents the results so obtained.

Further, the test sample having the component ratio of 0.1 for X was measured of resonance frequency before and after left in the thermostatic oven as in the Embodiment Example 1 and the rate of change for resonance frequency between before and after left in the oven was calculated also as in the Embodiment Example 1. The results so obtained were found to be equivalent to those in the Embodiment Example 1.

Embodiment Example 9:

The industrial-use metal oxide powders used were the lead oxide (PbO), titanium oxide ($TiO_2$), zirconium oxide ($ZrO_2$), zinc oxide (ZnO) and tungsten oxide ($WO_3$) powders. They were accurately weighed so as to be able to obtain a composition expressed by the chemical formula below.

$$(1-X)Pb_{1.02}(Ti_{0.48}Zr_{0.52})O_3 \; + \; X \cdot Pb_{1.02}(Zn_{1/2}W_{1/2})O_3,$$

where $O<X \leq 0.15$.

Test samples were prepared in the same manner as in the Embodiment Example 1 except that the first mixture of the industrial-use metal oxide powders comprised the zirconium oxide, zinc oxide, and tungsten oxide powders.

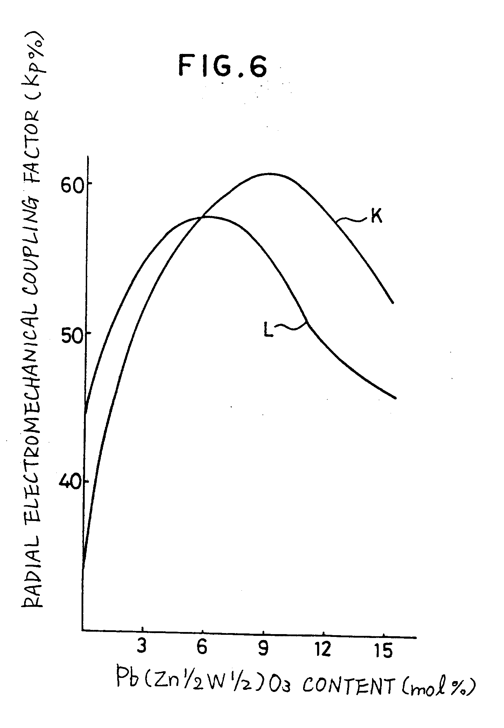

The radial electromechanical coupling factor of each test sample was measured also in the same manner as in the Embodiment Example 1. The results obtained are indicated by the curve K in Fig. 6.

Further, the test sample having the component ratio of 0.1 for X was measured of resonance frequency before and after left in the thermostatic oven as in the Embodiment Example 1 and the rate of change for resonance frequency between before and after left in the oven was calculated also as in the Embodiment Example 1. The results so obtained were found to be equivalent to those in the Embodiment Example 1.

Embodiment Example 10:

The industrial-use metal oxide powders used were the lead oxide (PbO), titanium oxide ($TiO_2$), zirconium oxide ($ZrO_2$), zinc oxide (ZnO), tungsten oxide ($WO_3$), niobium oxide ($Nb_2O_5$), nickel oxide (NiO), and zinc oxide (ZnO) powders. They were accurately weighed so as to be able to obtain a composition expressed by the chemical formula below.

$$(1-X)Pb_{1.02}[\ (Ni_{1/3}Nb_{2/3})_{0.28}(Zn_{1/3}Nb_{2/3})_{0.12}\ .\ Ti_{0.29}Zr_{0.31}]O_3\ +\ X\ .\ Pb_{1.02}(Zn_{1/2}W_{1/2})O_3,$$

where $O < X \leq 0.15$.

Test samples were prepared in the same manner as in the Embodiment Example 1 except that the first mixture of the industrial-use metal oxide powders comprised the zirconium oxide, zinc oxide, tungsten oxide, nickel oxide, and niobium oxide powders.

Also in the same manner as in the Embodiment Example 1, the radial electromechanical coupling factor of each test sample was measured. The results obtained are indicated by the curve L in Fig. 6.

Further, the test sample having the component ratio of 0.1 for X was measured of resonance frequency before and after left in the thermostatic oven as in the Embodiment Example 1 and the rate of change for resonance frequency between before and after left in the oven was calculated also as in the Embodiment Example 1. The results so obtained were found to be equivalent to those in the Embodiment Example 1.

Embodiment Example 11:

Test samples here were prepared in the same manner as in the Embodiment Example 1 except that the sintering temperature was set at 800°C.

Also in the same manner as in the Embodiment Example 1, the radial electromechanical coupling factor of each test sample was measured. The results so obtained are shown as the curve M in Fig. 1.

Further, the test sample having the component ratio of 0.1 for X was measured of resonance frequency before and after left in the thermostatic oven as in the Embodiment Example 1 and the rate of change for resonance frequency between before and after left in the oven was calcualted also as in the Embodiment Example 1. The results so obtained are shown as the curve N in Fig. 2.

Embodiment Example 12:

Test samples were prepared in the same manner as in the Embodiment Example 2 except that the sintering temperature was set at 800°C.

Also in the same manner as in the Embodiment Example 1, the radial electromechanical coupling factor of each test sample was measured. The curve O in Fig. 1 represents the results so obtained.

Further, the test sample having the component ratio of 0.1 for X was measured of resonance frequency before and after left in the thermostatic oven as in the Embodiment Example 1 and the rate of change for resonance frequency between before and after left in the oven was calculated also as in the Embodiment Example 1. The results so obtained were found to be equivalent to those in the Embodiment Example 11.

Embodiment Example 13:

The industrial-use metal oxide powders used were the lead oxide (PbO), titanium oxide ($TiO_2$), zirconium oxide ($ZrO_2$), zinc oxide (ZnO), iron oxide ($Fe_2O_3$), tungsten oxide ($WO_3$), niobium oxide ($Nb_2O_5$), and nickel oxide (NiO) powders. They were accurately weighed so as to be able to obtain a composition expressed by the chemical formula below.

$$(1-X)PbO_{1.02}[(Ni_{1/3}Nb_{2/3})_{0.28}(Zn_{1/3}Nb_{2/3})_{0.12}.Ti_{0.31}\ Zr_{0.29}]O_3\ +\ X\ .\ Pb_{1.02}[\ (Fe_{2/3}W_{1/3})_{0.50}(Zr_{1/2}W_{1/2})_{0.50}]O_3,$$

7

where $0 < X \leq 0.15$.

Test samples were prepared in the same manner as in the Embodiment Example 1 except the the first mixture of the industrial-use metal oxide powders comprised the zirconium oxide, nickel oxide, niobium oxide, iron oxide, zinc oxide, and tungsten oxide powders.

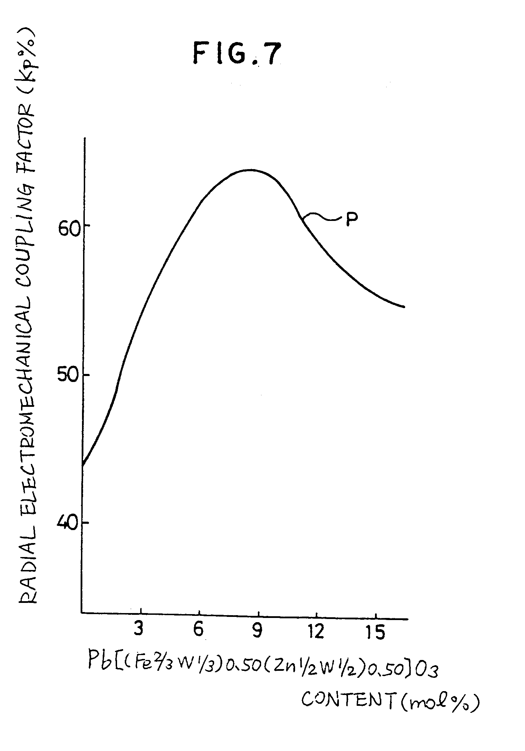

Also in the same manner as in the Embodiment Example 1, the radial electromechanical coupling factor of each test sample was measured. The results obtained are indicated by the curve P in Fig. 7.

Further, the test sample having the component ratio of 0.1 for X was measured of resonance frequency before and after left in the thermostatic oven as in the Embodiment Example 1 and the rate of change for resonance frequency between before and after left in the oven was calculated also as in the Embodiment Example 1. The results so obtained were found to be equivalent to those in the Embodiment Example 1.

Example 14 (Comparative):

The indstrial-use metal oxide powders used were the lead oxide (PbO), titanium oxide ($TiO_2$), zirconium oxide ($ZrO_2$), sodium fluoride (NaF), and lead fluoride ($PbF_2$) powders. They were accurately weighed so as to be able to obtain a composition expressed by the chemical formula below.

$$Pb(Ti_{0.48}Zr_{0.52})O_3 \; + \; X \, . \, (NaF_{0.33}PbF_{0.67}),$$

where $0 < X \leq 0.15$.

Test samples were prepared in the same manner as in the Embodiment Example 1 except that the first mixture of the industrial-use metal oxide powders comprised the lead oxide, titanium oxide, and zirconium oxide powders and the remaining sodium floride and lead fluoride powders which had been calcined at 450°C previously for one hour were added to the calcined powder obtained by calcining the foregoing mixture.

The radial electromechanical coupling factor of each test sample was measured in the same manner as in the Embodiment Example 1 to find out that the maximum value thereof for the test sample having the component ratio of 0.1 for X was 52%.

In addition, the test sample having the component ratio of 0.1 for X was further measured of resonance frequency before and after left in the thermostatic oven in the same manner as in the Embodiment Example 1 and the rate of change for resonance frequency between before and after left in the oven was calculated also as in the Embodiment Example 1. The results so obtained are shown in Fig. 2 as the curve D.

As is clear from Fig. 2, whereas the piezoelectric ceramic manufactured according to the present invention shows that the rate of change for resonance frequency remains constant even when left under the severe condition with the temperature of 85°C and relative humidity of 90%RH for over 1,000 hours, the piezoelectric ceramics obtained through a sintering process in which sodium fluoride and lead fluoride were used as a sintering temperature depressant according to a conventional method showed that said rate of change for resonance frequency increased gradually with progress of time. Furthermore, as is clear from Figs. 1, 3, 4, 5, 6 and 7, the electromechanical coupling factor for each of the piezoelectric ceramics prepared according to the Embodiment Examples 1 through 13 indicates no problem with respect to their practicability.

(Effects of the Invention)

As described in the foregoing, a piezoelectric ceramic manufactured through a comparatively low-temperature sintering process according to the present invention possesses such a superb dampproof property that its electrical characteristics remain undeteriorated even after it has been left in a high-humidity condition of 90% RH or higher for over 1000 hours. In addition, it has an electromechanical coupling factor good enough to meet the practical purpose.

Furthermore, according to the manufacturing method of piezoelectric ceramics proposed by the present invention, the material used to manufacture a piezoelectric ceramic according to the present invention contains a lead system oxide as its main component and in addition thereto tungsten oxide plus at least one of iron oxide, copper oxide, cobalt oxide, nickel oxide and zinc oxide, all of them being an oxide and thus not eluted in an aqueous solvent, so that the component ratio is uniform not only in a piezoelectric ceramic obtained according to said method but also between said ceramics of different lots. Furthermore, such a solid solution as lead iron tungstate $[Pb(Fe_{2/3}W_{1/3})O_3]$, lead copper tungstate $[Pb(Cu_{1/2}W_{1/2})O_3]$, lead cobalt tungstate $[Pb(Co_{1/2}W_{1/2})O_3]$, lead nickel tungstate $[Pb(Ni_{1/2}W_{1/2})O_3]$, or lead zinc tungstate $[Pb(Zn_{1/2} W_{1/2})$-

$O_3$] formed when the foregoing material substances are mixed and sintered acts as a sintering temperature depressant, thus enabling to carry out a low temperature sintering successfully. These are the advantages brought about by the present invention.

## Claims

1.  A piezoelectric ceramic mainly composed of lead system oxide containing a tungstate, characterized in that it contains at least one of lead iron tungstate [Pb(Fe$_{2/3}$W$_{1/3}$)O$_3$], lead copper tungstate [Pb(Cu$_{1/2}$W$_{1/2}$)O$_3$], lead cobalt tungstate [Pb(Co$_{1/2}$W$_{1/2}$)O$_3$], lead nickel tungstate [Pb(Ni$_{1/2}$W$_{1/2}$)O$_3$], and lead zinc tungstate [Pb(Zn$_{1/2}$W$_{1/2}$)O$_3$], and an A-site/B-site molar ratio thereof is 1.01 or higher, except for the lead oxide tungstate-containing ceramics of the general formula Pb[(Ni$_{1/3}$Nb$_{2/3}$)a (Zn$_{1/3}$Nb$_{2/3}$)$_b$ - (Fe$_{2/3}$W$_{1/3}$)$_c$ (Ti$_x$Zr$_y$)$_d$]O$_3$, wherein $a+b+c+d=1$, $0.20<a+b<0.50$, $0.02<c<0.15$, and $x+y=1$, the materials of the formulae Pb$_{1.02}$(Mg$_{1/3}$Nb$_{2/3}$)$_{0.70}$ Ti$_{0.18}$(Ni$_{1/2}$W$_{1/2}$)$_{0.12}$O$_{3.02}$ + optionally certain amounts of Cu$_2$O, and the ceramic compositions comprising the ceramic components expressed as PbTi$_x$-(Mg$_{1/3}$Nb$_{2/3}$)$_y$ (Ni$_{1/2}$W$_{1/2}$)$_z$O$_3$, wherein $x+y+z=1$ and, in the system of trigonometric coordinates having the vertices at PbTiO$_3$, Pb(Mg$_{1/3}$Nb$_{2/3}$)O$_3$ and Pb(Ni$_{1/2}$W$_{1/2}$)O$_3$, PbO by 1.0 to 25.0 mol% and NiO or WO$_3$ by 1.0 to 15.0 mol% are added as subsidiary components to the temporarily baked powder of the main component dielectric composition formed in the pentagonal region having vertices at components A.B.C.D.E expressed by the numerical values in the following square bracket, [A is $x=2.5$, $y=95.0$, $z=2.5$; B is $x=12.5$, $y=85.0$, $z=2.5$; C is $x=60.0$, $y=10.0$, $z=30.0$; D is $x=40.0$, $y=10.0$, $z=50.0$; E is $x=2.5$, $y=90.0$, $z=7.5$ (where all units are mol%)].

2.  A piezoelectric ceramic according to claim 1, wherein the A-site/B-site molar ratio is 1.01 to 1.03.

3.  A manufacturing method of a piezoelectric ceramic according to claim 1, in which material powders for the piezoelectric ceramic mainly composed of a lead system oxide containing a tungstate are mixed and sintered to manufacture the piezoelectric ceramic, characterized in that a mixture of the material powders arranged to comprise tungsten oxide and in addition thereto at least one of iron oxide, copper oxide, cobalt oxide, nickel oxide and zinc oxide and adjusted to have the A-site/B-site molar ratio of 1.01 or higher is sintered so that the piezoelectric ceramic mainly composed of the lead system oxide has in solid solution at least one of lead iron tungstate [Pb(Fe$_{2/3}$W$_{1/3}$)O$_3$], lead copper tungstate [Pb(Cu$_{1/2}$W$_{1/2}$)O$_3$], lead cobalt tungstate [Pb(Co$_{1/2}$W$_{1/2}$)O$_3$], lead nickel tungstate [Pb(Ni$_{1/2}$W$_{1/2}$)O$_3$], and lead zinc tungstate [Pb(Zn$_{1/2}$W$_{1/2}$)O$_3$].

## Patentansprüche

1.  Piezoelektrische Keramik, hauptsächlich zusammengesetzt aus ein Wolframat enthaltendem Bleisystemoxid, dadurch gekennzeichnet, daß es mindestens ein Bleieisenwolframat [Pb(Fe$_{2/3}$W$_{1/3}$)O$_3$], Bleikupferwolframat [Pb(Cu$_{1/2}$W$_{1/2}$)O$_3$], Bleikobaltwolframat [Pb(Co$_{1/2}$W$_{1/2}$)O$_3$], Bleinickelwolframat [Pb(Ni$_{1/2}$W$_{1/2}$)O$_3$] und Bleizinkwolframat [Pb(Zn$_{1/2}$W$_{1/2}$)O$_3$] enthält, wobei ein A-Stelle/B-Stelle Molverhältnis davon 1,01 oder höher ist, außer Bleioxidwolframat-enthaltende Keramiken der allgemeinen Formel Pb[-(Ni$_{1/3}$Nb$_{2/3}$)$_a$ (Zn$_{1/3}$Nb$_{2/3}$)$_b$ (Fe$_{2/3}$W$_{1/3}$)$_c$ (Ti$_x$Zr$_y$)$_d$]O$_3$, wobei $a+b+c+d=1$, $0,20<a+b<0,50$, $0,20<c<0,15$ und $x+y=1$, den Materialien der Formeln Pb$_{1,02}$(Mg$_{1/3}$Nb$_{2/3}$)$_{0,70}$Ti$_{0,18}$(Ni$_{1/2}$W$_{1/2}$)$_{0,12}$O$_{3,02}$ + gegebenenfalls gewisse Mengen an Cu$_2$O, und den Keramikzusammensetzungen, umfassend die Keramikkomponenten, ausgedrückt als PbTi$_x$(Mg$_{1/3}$Nb$_{2/3}$)$_y$(Ni$_{1/2}$W$_{1/2}$)$_z$O$_3$, wobei $x+y+z=1$, und im trigonometrischen Koordinatensystem mit den Ecken bei PbTiO$_3$, Pb(Mg$_{1/3}$Nb$_{2/3}$)O$_3$ und Pb(Ni$_{1/2}$W$_{1/2}$)O$_3$, PbO von 1,0 bis 25,0 Mol-% und NiO oder WO$_3$ mit 1,0 bis 15 Mol-% als Hilfskomponenten zum vorläufig gebackenen Pulver der dielektrischen Verbindung als Hauptkomponente, die durch eine pentagonale Region mit den Ecken bei den Komponenten A.B.C.D.E gebildet wird, ausgedrückt durch die Zahlenwerte in der folgenden eckigen Klammer [A ist $x=2,5$, $y=95,0$, $z=2,5$; B ist $x=1,25$, $y=85,0$, $z=2,5$; C ist $x=60,0$, $y=10,0$, $z=30,0$; D ist $x=40,0$, $y=10,0$, $z=50,0$; E ist $x=2,5$, $y=90,0$, $z=7,5$ (alle Einheiten sind Mol-%)], zugegeben werden.

2.  Piezoelektrische Keramik gemäß Anspruch 1, wobei das A-Stelle/B-Stelle Molverhältnis 1,01 bis 1,03 ist.

3.  Verfahren zur Herstellung einer piezoelektrischer Keramik gemäß Anspruch 1, in der Materialpulver für die piezoelektrische Keramik, hauptsächlich aus einem ein Wolframat enthaltendes Bleisystemoxid zusammengesetzt, gemischt und gesintert werden, um die piezoelektrische Keramik herzustellen, dadurch gekennzeichnet, daß ein Gemisch der Materialpulver, das bearbeitet wird, um Wolframoxid und zusätzlich dazu mindestens ein Eisenoxid, Kupferoxid, Kobaltoxid, Nickeloxid und Zinkoxid zu umfassen und das eingestellt wird um ein A-Stelle/B-Stelle Verhältnis von 1,01 oder höher zu haben, gesintert wird, so daß die piezoelektrische Keramik, die hauptsächlich aus einem Bleisystemoxid zusammengesetzt ist, als Mischkristall mindestens ein Bleieisenwolframat [Pb(Fe$_{2/3}$W$_{1/3}$)O$_3$], Bleikupfervolframat [Pb(Cu$_{1/2}$W$_{1/2}$)O$_3$], Bleikobaltwolframat [Pb(Co$_{1/2}$W$_{1/2}$)O$_3$], Bleinickelwolframat[Pb(Ni$_{1/2}$W$_{1/2}$)O$_3$] und Bleizinkwolframat [Pb(Zn$_{1/2}$W$_{1/2}$)O$_3$] hat.

## Revendications

**1.** Céramique piézo-électrique composée principalement d'un oxyde à base de plomb contenant un tungstate, caractérisée en ce qu'elle contient au moins un composé parmi le tungstate de fer et de plomb [Pb(Fe$_{2/3}$W$_{1/3}$)O$_3$], le tungstate de cuivre et de plomb [Pb(Cu$_{1/2}$W$_{1/2}$)O$_3$], le tungstate de cobalt et de plomb [Pb(Co$_{1/2}$W$_{1/2}$)O$_3$], le tungstate de nickel et de plomb [Pb(Ni$_{1/2}$W$_{1/2}$)O$_3$] et le tungstate de zinc et de plomb [Pb(Zn$_{1/2}$W$_{1/2}$)O$_3$], et en ce qu'un rapport molaire site A/site B de celle-ci vaut 1,01 ou plus, sauf pour les céramiques à l'oxyde de plomb contenant un tungstate de la formule générale Pb[(Ni$_{1/3}$Nb$_{2/3}$)$_a$(Zn$_{1/3}$Nb$_{2/3}$)$_b$(Fe$_{2/3}$W$_{1/3}$)$_c$(Ti$_x$Zr$_y$)$_d$]O$_3$, dans laquelle $a+b+c+d=1$, $0,20<a+b<0,50$, $0,02<c<0,15$, et $x+y=1$, les matériaux de la formule Pb$_{1,02}$(Mg$_{1/3}$Nb$_{2/3}$)$_{0,70}$Ti$_{0,18}$(Ni$_{1/2}$W$_{1/2}$)$_{0,12}$O$_{3,02}$ + certains montants de Cu$_2$O optionnellement, et les compositions céramiques comprenant les composés céramiques exprimés par PbTi$_x$(Mg$_{1/3}$Nb$_{2/3}$)$_y$(Ni$_{1/2}$W$_{1/2}$)$_z$O$_3$, dans laquelle $x+y+z=1$ et, dans le système de coordonnées trigonométriques ayant les sommets en PbTiO$_3$, Pb(Mg$_{1/3}$Nb$_{2/3}$)O$_3$ et Pb(Ni$_{1/2}$W$_{1/2}$)$_z$O$_3$, 1,0 à 25,0% en moles de PbO et 1,0 à 15,0% en moles de NiO ou WO$_3$ sont ajoutés comme composés auxiliaires à la poudre cuite temporairement de la composition diélectrique des composés principaux formée dans la région pentagonale ayant des sommets aux composés A.B.C.D.E exprimés par les valeurs numériques dans les crochets suivants, [A représente $x=2,5$, $y=95,0$, $z=2,5$; B représente $x=12,5$, $y=85,0$, $z=2,5$; C représente $x=60,0$, $y=10,0$, $z=30,0$; D représente $x=40,0$, $y=10,0$, $z=50,0$, E représente $x=2,5$, $y=90,0$, $z=7,5$ (où toutes les unités sont en % en moles)].

**2.** Céramique piézo-électrique selon la revendication 1, dans laquelle le rapport molaire site A/site B vaut 1,01 à 1,03.

**3.** Procédé de production d'une céramique piézoélectrique selon la revendication 1, dans lequel des poudres de matériaux pour la céramique piézo-électrique composée principalement d'un oxyde à base de plomb contenant un tungstate sont mélangées et frittées pour produire la céramique piézo-électrique, caractérisé en ce qu'un mélange des poudres de matériaux, arrangé pour comprendre de l'oxyde de tungstène et en addition à cet oxyde au moins un composé parmi l'oxyde de fer, l'oxyde de cuivre, l'oxyde de cobalt, l'oxyde de nickel et l'oxyde de zinc et ajusté pour avoir le rapport molaire site A/site B de 1,01 ou plus, est fritté de telle sorte que la céramique piézo-électrique composée principalement de l'oxyde à base de plomb a en solution solide au moins un composé parmi le tungstate de fer et de plomb [Pb(Fe$_{2/3}$W$_{1/3}$)O$_3$], le tungstate de cuivre et de plomb [Pb(Cu$_{1/2}$W$_{1/2}$)O$_3$], le tungstate de cobalt et de plomb [Pb(Co$_{1/2}$W$_{1/2}$)O$_3$], le tungstate de nickel et de plomb [Pb(Ni$_{1/2}$W$_{1/2}$)O$_3$] et le tungstate de zinc et de plomb [Pb(Zn$_{1/2}$W$_{1/2}$)O$_3$].

# FIG.1

FIG.2

# FIG.3

Graph with vertical axis "RADIAL ELECTROMECHANICAL COUPLING FACTOR (kp%)" marked 40, 50, 60 and horizontal axis "Pb(Cu 1/2 W 1/2) O₃ CONTENT (mol%)" marked 3, 6, 9, 12, 15. Two curves labeled E and F.

FIG.4

# FIG.5

FIG.6

# FIG.7

Graph — x-axis: $Pb[(Fe_{2/3}W_{1/3})_{0.50}(Zn_{1/2}W_{1/2})_{0.50}]O_3$ CONTENT (mol%), marked 3, 6, 9, 12, 15. y-axis: RADIAL ELECTROMECHANICAL COUPLING FACTOR ($k_P\%$), marked 40, 50, 60. Curve labeled P.